# EUROPEAN PATENT APPLICATION

(11) **EP 4 709 070 A1**
(43) Date of publication of application: **11.03.2026**
(21) Application number: 25198026.4
(22) Date of filing: 26.08.2025
(51) Int. Cl.: H05K 7/20

(54) **SYSTEMS AND METHODS FOR WATER COOLED PRE-SYSTEM**

(30) Priority: 26.08.2024 US 202463687075 P; 25.08.2025 US 202519308671
(71) Applicant: Vertiv Corporation, Westerville, OH 43082 (US)
(72) Inventor: SPIEGEL, Phillip Wayne, Westerville, 43082 (US)
(74) Representative: Bryn-Jacobsen, Caelia

(57) **Abstract**

A system for data center cooling includes: a first cooling unit configured to circulate refrigerant; a second cooling unit configured to circulate coolant; and a heat exchanger system in fluid communication with the first cooling unit and the second cooling unit, the heat exchanger system being configured to exchange heat between the refrigerant and the coolant.

## Description

### CROSS REFERENCE TO RELATED APPLICATIONS

This U.S. Non-Provisional Patent Applications claims the benefit of and priority to U.S. Provisional Patent Application Serial No. 63/687,075 filed August 26, 2024, and U.S. Patent Application Serial No. 19/308,671 filed August 25, 2025.

### TECHNICAL FIELD

This disclosure relates to device cooling systems, and, in particular, to systems and methods for a water cooled pre-system.

### BACKGROUND

A data hall may comprise various processing units and/or computing systems that generate heat. Accordingly, cooling such processing units and/or computing systems is critically important to avoid overheating, which may result in damage or reduced useful life of the processing units and/or computing systems. Space in data halls is typically limited, given the tightly packed configurations of such data halls. As such, cooling such processing units and/or computing systems of a data hall is bounded by space requirements and the need for efficient use of the space, while continuing to provide adequate cooling.

### SUMMARY

An aspect of the disclosed example includes a system for a water cooled pre-system for data halls. The system includes a condenser assembly configured to direct a flow of water to one or more processing units using one or more rods of a heat exchanger assembly.

Another aspect of the disclosed examples includes a system for a water cooled pre-system for data halls. The system includes: a heat exchanger system disposed in a cabinet and configured to direct a flow of water to one or more processing units using one or more rods; an outdoor heat exchanger disposed outside of a building associated with the cabinet, the outdoor heat exchanger being configured to communicate with the heat exchanger; and a fluid tank disposed outside of the cabinet and configured to communicate with the heat exchanger.

Another aspect of the disclosed examples includes a system for a water-cooled pre-system for data halls. The system includes: an outdoor unit disposed outside a building and configured to circulate refrigerant; an indoor unit disposed inside the building and configured to circulate coolant; a heat exchanger system having one or more rods in a cabinet and fluidically communicating with the outdoor unit and indoor unit, the heat exchanger system configured to receive coolant from the indoor unit through a first path of each of the one or more rods and to receive refrigerant through a second path of each of the one or more rods for heat exchange between coolant and refrigerant; a fluid tank disposed outside of the cabinet and configured to communicate with the heat exchanger; and a pump configured to circulate coolant.

Another aspect of the disclosed examples includes a system for data center cooling. The system includes: a first cooling unit configured to circulate refrigerant; a second cooling unit configured to circulate coolant; and a heat exchanger system in fluid communication with the first cooling unit and the second cooling unit, the heat exchanger system being configured to exchange heat between the refrigerant and the coolant.

Another aspect of the disclosed examples includes a heat exchanger that includes a housing configured to house one or more rods. Each of the one or more rods includes: a first path configured to receive coolant from a first cooling unit; and a second path configured to receive refrigerant from a second cooling unit, each of the one or more rods being configured to exchange heat between the refrigerant and the coolant.

### BRIEF DESCRIPTION OF THE DRAWINGS

The above and/or other aspects will become apparent and more readily appreciated from the following description of examples, taken in conjunction with the accompanying drawings, in which:
FIG. 1 generally illustrates a data hall, according to the principles of the present disclosure.
FIGS. 2-4 generally illustrate a water cooled pre-system, according to the principles of the present disclosure.

### DETAILED DESCRIPTION

Reference will now be made in detail to examples which are illustrated in the accompanying drawings, wherein like reference numerals refer to like elements throughout. In this regard, the examples may have different forms and may not be construed as being limited to the descriptions set forth herein.

It will be understood that the terms "include," "including," "comprise," and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

Various terms are used to refer to particular system components. Different companies may refer to a component by different names - this document does not intend to distinguish between components that differ in name but not function.

Matters of these examples that are obvious to those of ordinary skill in the technical field to which these examples pertain may not be described herein in detail.

It may be understood that the examples described herein may be considered in a descriptive sense only and not for purposes of limitation. Descriptions of features or aspects within each example may be considered as available for other similar features or aspects in other examples.

As described, a data hall may comprise various processing units and/or computing systems that generate heat. Accordingly, cooling such processing units and/or computing systems is critically important to avoid overheating, which may result in damage or reduced useful life of the processing units and/or computing systems. Space in data halls is typically limited, given the tightly packed configurations of such data halls. As such, cooling such processing units and/or computing systems of a data hall is bounded by space requirements and the need for efficient use of the space, while continuing to provide adequate cooling.

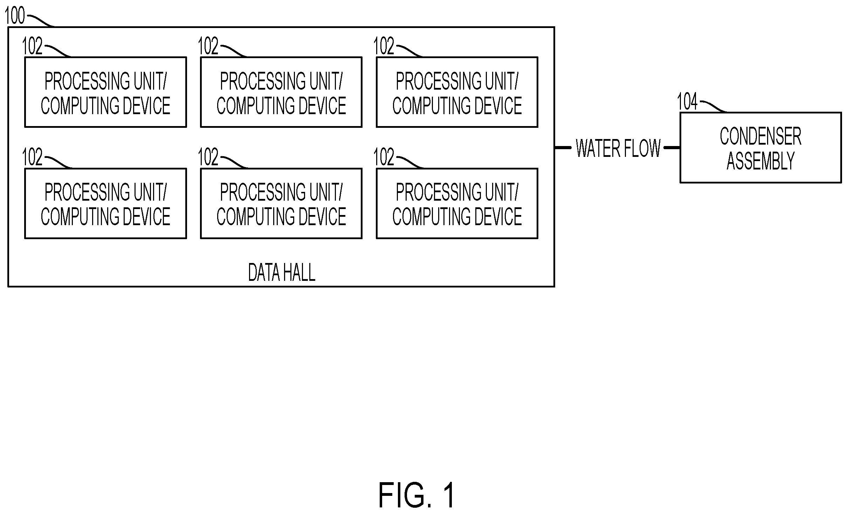

Accordingly, systems and methods, such as the systems and methods described herein, configured to provide a water cooled pre-system for data halls, may be desirable. With reference to FIG. 1, in some examples, the systems and methods described herein may be configured to remove heat using water while keeping refrigerant outside of a data hall 100. The data hall 100 may include various processing units/computing systems 102. A condenser assembly 104 may be configured to direct cold water to the data hall to provide cooling of the various processing units/computing systems 102. The condenser assembly 104 may be associated with various products including, but not limited to, DP400 and DO 500 products.

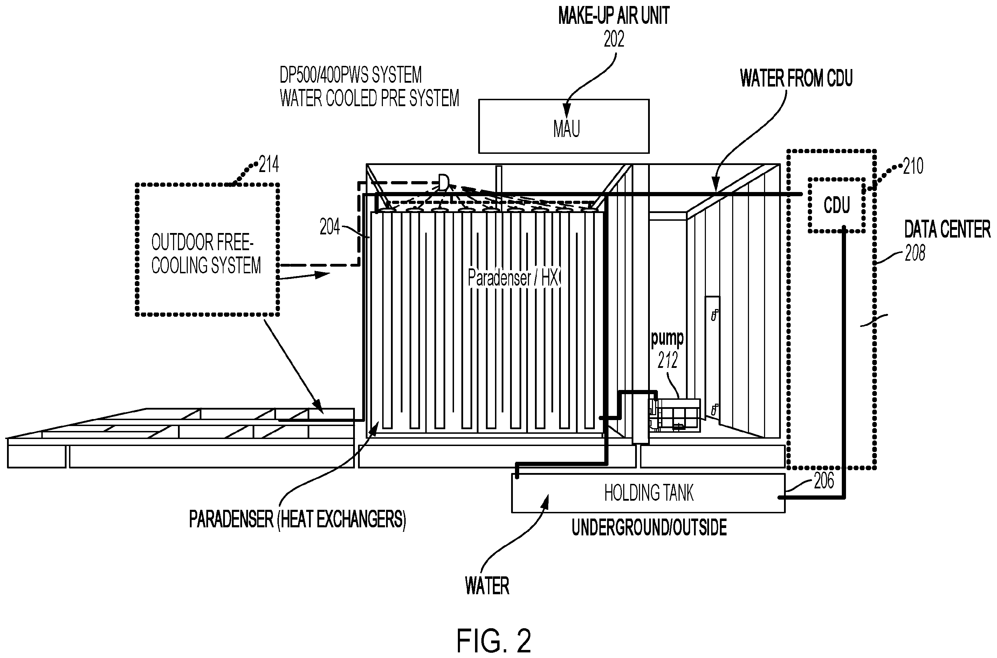

As is generally illustrated in FIGS. 2-4, the systems and methods described herein may be configured to use or provide a heat exchanger system 204 (referred to as paradenser/HX in FIG. 2) configured to provide cooling features, while being configured to withstand cleaning and other maintenance. The system 204, which may be also called a "paradenser," is described in U.S. 12/262,259, the contents of which are incorporated herein by reference in their entirety. The system 204 may include a series of condensers or heat exchangers as illustrated in FIGS. 2-4.

In some examples, paradensers of the system 204 may be configured as tubes and include two or more fluid paths within each tube. For example, one path may include a refrigerant path and the other path may include a water flow path. The two paths may be used for heat exchange. The tubes and/or the system 204 may be disposed in a cabinet or housing within a data center 208. The data center 208 may include the data hall 100 and/or include features similar to those of the data hall 100.

The system 204 may be configured to move cold water (e.g., water at a temperature below a threshold temperature) directly to information technology (IT) loads (e.g., associated with various processing units and/or computing systems 102) of the data hall 100 that generate heat and, accordingly, are cooled by the cold water. A make-up air unit (MAU) 202 may be configured to condition air flowing into an area surrounding the system 204.

The system 204 may use existing condenser assemblies 104 to direct the flow of the cold water. In some examples, the system 204 may allow water to flow from a coolant distribution unit (CDU) 210 of a data center 208 to the heat exchanger of the system 204 (e.g., with hot water from the servers of the data center exchanging the heat with refrigerant) to a holding tank 206 via a pump 212 and back to the CDU 210. The holding tank 206 may be located underground or external to the data center 208 (e.g., outside of the building).

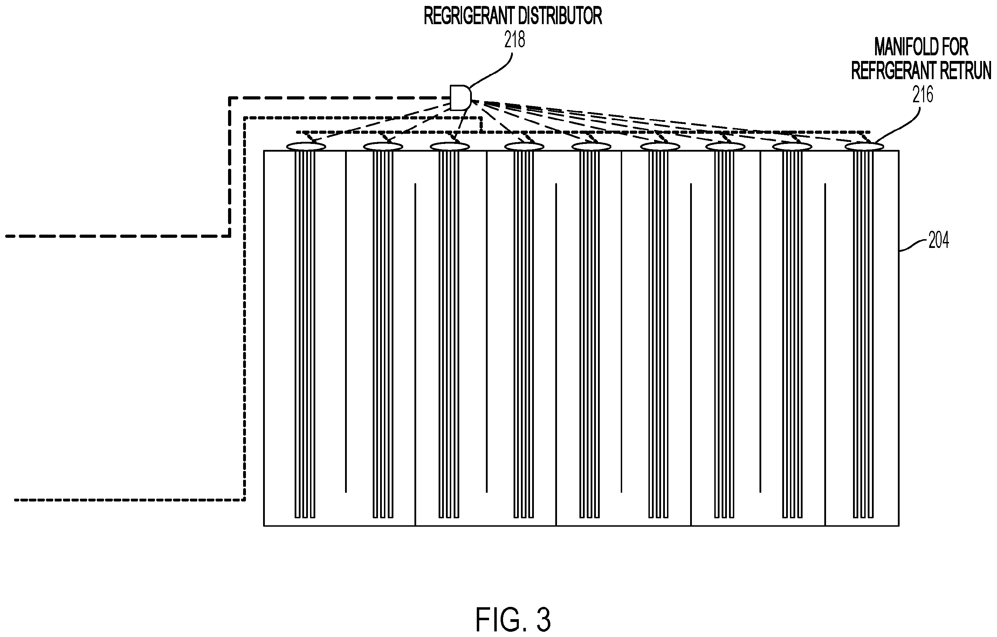

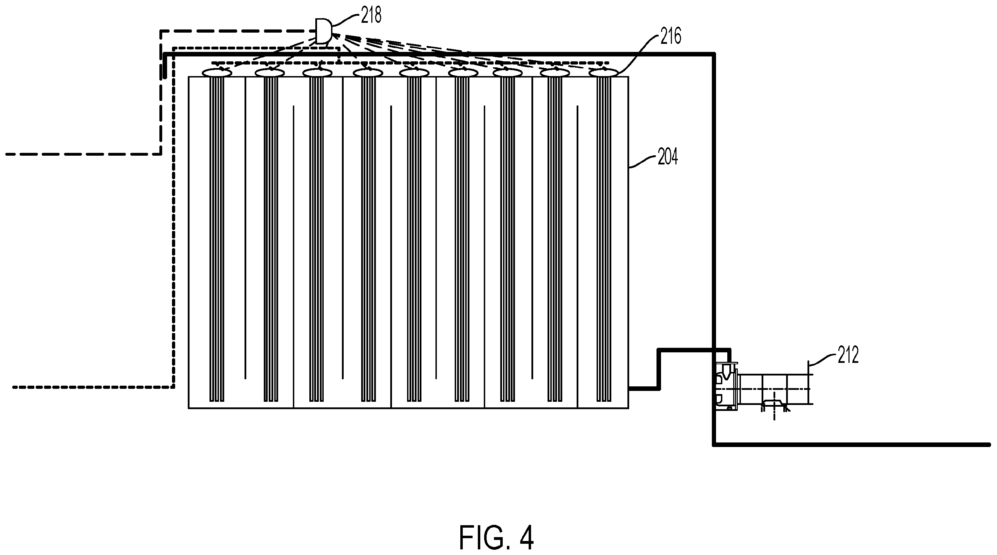

Additionally, or alternatively, the system 204 may be configured to allow refrigerant to flow from an outdoor free-cooling system 214 (e.g., Liebert DSE or DP500) via a first path via a refrigerant distributor 218 (e.g., as is generally illustrated in FIGS. 3 and 4) to the system 204, back to the free-cooling system 214 via a second path via a manifold 216 for refrigerant return as vapor (e.g., from heat exchanging with water inside the paradensers of the system 204).

The system 204 may be configured to direct the flow of cold water through heat exchangers (e.g., which may also be referred to as condenser coils, coils, and/or the like). The system 204 may be configured to use existing rods inside of the system 204. The system 204 may be configured to provide direct-to-chip cooling of IT loads and/or artificial intelligence (AI) loads.

In some examples, a system for a water cooled pre-system for data halls includes a condenser assembly configured to direct a flow of water to one or more processing units using one or more rods of a heat exchanger assembly.

In some examples, a system for data center cooling includes: a first cooling unit configured to circulate refrigerant; a second cooling unit configured to circulate coolant; and a heat exchanger system in fluid communication with the first cooling unit and the second cooling unit, the heat exchanger system being configured to exchange heat between the refrigerant and the coolant.

In some examples, the first cooling unit is located within a building that includes the heat exchanger system. In some examples, the first cooling unit is in fluid communication with a holding tank. In some examples, the holding tank is located outside of the building that includes the heat exchanger system. In some examples, the holding tank is disposed underground. In some examples, the second cooling unit is located outside of a building that includes the heat exchanger system. In some examples, the heat exchanger system includes one or more rods. In some examples, each rod of the one or more rods includes a first path and a second path. In some examples, the first path of each rod of the one or more rods is configured to receive coolant, from the first cooling unit. In some examples, the second path of each rod of the one or more rods is configured to receive refrigerant from the second cooling unit. In some examples, wherein the system also includes a pump configured to circulate the coolant of the first cooling unit. In some examples, the data center is associated with information technology computing devices. In some examples, the data center is associated with artificial intelligence computing devices.

In some examples, a heat exchanger includes a housing configured to house one or more rods. Each of the one or more rods includes: a first path configured to receive coolant from a first cooling unit; and a second path configured to receive refrigerant from a second cooling unit, each of the one or more rods being configured to exchange heat between the refrigerant and the coolant.

In some examples, the first cooling unit is located within a building that includes the housing. In some examples, the first cooling unit is in fluid communication with a holding tank. In some examples, the holding tank is located outside of the building. In some examples, the holding tank is disposed underground. In some examples, the second cooling unit is located outside of a building that includes the housing. In some examples, a pump, located within a building that includes the housing, is configured to circulate coolant.

In some examples, a system for a water cooled pre-system for data halls includes: a heat exchanger system disposed in a cabinet and configured to direct a flow of water to one or more processing units using one or more rods; an outdoor heat exchanger disposed outside of a building associated with the cabinet, the outdoor heat exchanger being configured to communicate with the heat exchanger; and a fluid tank disposed outside of the cabinet and configured to communicate with the heat exchanger.

Further examples are set out in the clauses below:
1. A system for data center cooling, the system comprising:
   a first cooling unit configured to circulate refrigerant;
   a second cooling unit configured to circulate coolant; and
   a heat exchanger system in fluid communication with the first cooling unit and the second cooling unit, the heat exchanger system being configured to exchange heat between the refrigerant and the coolant.
2. The system of clause 1, wherein the first cooling unit is located within a building that includes the heat exchanger system.
3. The system of clause 2, wherein the first cooling unit is in fluid communication with a holding tank.
4. The system of clause 3, wherein the holding tank is located outside of the building that includes the heat exchanger system.
5. The system of clause 2 or 3, wherein the holding tank is disposed underground.
6. The system of any one of the preceding clauses, wherein the second cooling unit is located outside of a building that includes the heat exchanger system.
7. The system of any one of the preceding clauses, wherein the heat exchanger system includes one or more rods.
8. The system of clause 7, wherein each rod of the one or more rods includes a first path and a second path.
9. The system of clause 8, wherein the first path of each rod of the one or more rods is configured to receive coolant, from the first cooling unit.
10. The system of clause 8 or 9, wherein the second path of each rod of the one or more rods is configured to receive refrigerant from the second cooling unit.
11. The system of any one of the preceding clauses, further comprising a pump configured to circulate the coolant of the first cooling unit.
12. The system of any one of the preceding clauses, wherein the data center is associated with information technology computing devices.
13. The system of any one of the preceding clauses, wherein the data center is associated with artificial intelligence computing devices.
14. A heat exchanger comprising:
   a housing configured to house one or more rods, wherein each of the one or more rods includes:
   a first path configured to receive coolant from a first cooling unit; and
   a second path configured to receive refrigerant from a second cooling unit, each of the one or more rods being configured to exchange heat between the refrigerant and the coolant.
15. The heat exchanger of clause 14, wherein the first cooling unit is located within a building that includes the housing.
16. The heat exchanger of clause 14 or 15, wherein the first cooling unit is in fluid communication with a holding tank.
17. The heat exchanger of clause 16, wherein the holding tank is located outside of the building.
18. The heat exchanger of clause 16, wherein the holding tank is disposed underground.
19. The heat exchanger of clause 14, wherein the second cooling unit is located outside of a building that includes the housing.
20. The heat exchanger of clause 14, wherein a pump, located within a building that includes the housing, is configured to circulate coolant.

Further examples are set out in the item below:

A system for a water-cooled pre-system for data halls, the system comprising:
an outdoor unit disposed outside a building and configured to circulate refrigerant;
an indoor unit disposed inside the building and configured to circulate coolant;
a heat exchanger system having one or more rods in a cabinet and fluidically communicating with the outdoor unit and indoor unit, the heat exchanger system configured to receive coolant from the indoor unit through a first path of each of the one or more rods and to receive refrigerant through a second path of each of the one or more rods for heat exchange between coolant and refrigerant;
a fluid tank disposed outside of the cabinet and configured to communicate with the heat exchanger; and
a pump configured to circulate coolant.

While examples have been described with reference to the figures, it will be understood by those of ordinary skill in the art that various changes in form and details may be made therein without departing from the scope as defined by the following claims.

## Claims

1. A system for data center cooling, the system comprising:
a first cooling unit configured to circulate refrigerant;
a second cooling unit configured to circulate coolant; and
a heat exchanger system in fluid communication with the first cooling unit and the second cooling unit, the heat exchanger system being configured to exchange heat between the refrigerant and the coolant.

2. The system of claim 1, wherein the first cooling unit is located within a building that includes the heat exchanger system.

3. The system of claim 2, wherein the first cooling unit is in fluid communication with a holding tank.

4. The system of claim 3, wherein the holding tank is located outside of the building that includes the heat exchanger system.

5. The system of claim 3, wherein the holding tank is disposed underground.

6. The system of any one of the preceding claims, wherein the second cooling unit is located outside of a building that includes the heat exchanger system.

7. The system of any one of the preceding claims, wherein the heat exchanger system includes one or more rods.

8. The system of claim 7, wherein each rod of the one or more rods includes a first path and a second path.

9. The system of claim 8, wherein the first path of each rod of the one or more rods is configured to receive coolant, from the first cooling unit.

10. The system of claim 7 or 8, wherein the second path of each rod of the one or more rods is configured to receive refrigerant from the second cooling unit.

11. The system of any one of the preceding claims, further comprising a pump configured to circulate the coolant of the first cooling unit; or optionally
wherein the data center is associated with information technology computing devices; or optionally
wherein the data center is associated with artificial intelligence computing devices.

12. The system of any one of the preceding claims, wherein the heat exchange system comprises
a heat exchanger comprising:
a housing configured to house one or more rods, wherein each of the one or more rods includes:
a first path configured to receive coolant from the first cooling unit; and
a second path configured to receive refrigerant from the second cooling unit, each of the one or more rods being configured to exchange heat between the refrigerant and the coolant.

13. The system of claim 12, wherein the first cooling unit is located within a building that includes the housing; and optionally
wherein the first cooling unit is in fluid communication with a holding tank.

14. The system of claim 13, wherein the holding tank is located outside of the building; or optionally
wherein the holding tank is disposed underground.

15. The system of claim 12, wherein the second cooling unit is located outside of a building that includes the housing; or optionally
wherein a pump, located within a building that includes the housing, is configured to circulate coolant.
